# EUROPEAN PATENT SPECIFICATION

(11) **EP 1 739 827 B1**
(45) Date of publication and mention of the grant of the patent: **26.03.2008**
(21) Application number: 06013255.2
(22) Date of filing: 27.06.2006
(51) Int. Cl.: H03G 11/00

(54) **Radio frequency receiver including a limiter and related methods**
Funkempfänger mit einem Begrenzer und zugehörige Verfahren
Récepteur radiofréquence comportant un limiteur et méthodes correspondantes

(30) Priority: 27.06.2005 US 167335
(43) Date of publication of application: 03.01.2007
(73) Proprietor: HARRIS CORPORATION, Melbourne, Florida 32919 (US)
(72) Inventor: Hash, Ronald J., NE Palm Bay, FL 32907 (US); Taylor, Robert C., Melbourne, FL 32935 (US)
(74) Representative: Schmidt, Steffen J.

(56) References cited:
- US-A- 3 708 694
- US-A- 5 345 199
- US-A1- 2004 174 226
- US-B1- 6 747 484

## Description

### Field of the Invention

The invention relates to the field of radio frequency (RF) circuits, and, more particularly, to an RF limiter and related methods.

### Background of the Invention

A limiter restricts some characteristic of a signal waveform from exceeding a predetermined value within a circuit. A limiter is therefore generally used for wave shaping and circuit protection applications. An example of a limiter circuit used for RF wave shaping is U.S. Patent No. 3,206,617 to Scaroni, Jr., which discloses a limiter for eliminating unwanted amplitude modulation or noise carried by an RF signal. The limiter includes a pair of diodes connected in series opposition between the source and the load in combination with a pair of diodes connected in parallel opposition and connected in shunt across the source.

An example of a limiter used for circuit protection is U.S. Patent No. 6,853,264 to Bennett et al., which discloses a power limiter including a plurality of diodes connected in series to a plurality of transmission lines. The different transmission lines can have varying numbers of the series connected diodes thereby limiting the different transmission lines to different voltage levels. Similarly, U.S. Patent No. 6,784,837 to Revankar et al. discloses a transmit/receive module including a limiter that uses high breakdown voltage PIN diodes. The limiter operates in conjunction with a transmit/receive switch, which also uses high voltage PIN diodes, and a circulator to provide protection for the receiver circuit.

As noted above, a sensitive system circuit can be protected by a switching device, which serves to isolate the sensitive part of the circuit from exposure to excessive input power. For example, U.S. Patent No. 6,552,626 to Sharpe et al. discloses a protection system including a PIN diode single-pole, single-throw switch (SPST) isolating the receiver from high power transmission pulses of the transmitter in the event there is a bias failure, such as if the PIN diodes are at zero bias. The protection system uses one SPST switch assembly between the transmitter and the antenna and at least two SPST switch assemblies between the antenna and the receiver to achieve this isolation. Likewise, U.S. Patent No. 5,446,464 to Feldle discloses a transmit/receive switch connected to a transmitter and receiver signal path. The transmit/receive switch includes two semiconductor diodes and each semiconductor diode is coupled to an output of a power amplifier. The outputs of the power amplifiers can be selectively connected to ground thereby creating a short circuit.

Unfortunately, the RF limiters currently available may have significant drawbacks. The RF limiters that operate by providing a short circuit across the input terminals may cause incident energy, such as radar pulses, to be reflected. For broadband RF limiter applications, switches and tuned RF limiters are undesirable because both are typically hard limiters, they are either on or off. Circulators can address the reflection problem, but this is limited to narrow bandwidths, and integration of the circulators into some systems may be unwieldy.

### Summary of the Invention

In view of the foregoing background, it is therefore an object of the invention to provide an RF limiter having enhanced characteristics, such as relating to reflections and/or wide bandwidth.

This and other objects, features, and advantages in accordance with the invention are provided by a radio frequency (RF) receiver system including at least one antenna element, a receiver circuit, and at least one (RF) signal path connecting the at least one antenna element to the receiver circuit. A limiter may be connected to the RF signal path and include a positive voltage clamp for clamping the RF signal path to a positive threshold voltage relative to a voltage reference, and a negative voltage clamp for clamping the RF signal path to a negative threshold voltage relative to the voltage reference. The limiter does further include a controllable resistance connected in series with the RF signal path, and a control circuit for controlling the controllable resistance based upon at least one of the positive voltage clamp and the negative voltage clamp. Accordingly, the invention may provide a broadband RF limiter having enhanced reflection and/or wide bandwidth characteristics.

The control circuit may switch the controllable resistance from a low resistance to a high resistance based upon at least one of the positive voltage clamp and the negative voltage clamp clamping the RF signal path. The positive voltage clamp may include a first diode and at least one first resistance connected in series therewith between the RF signal path and the voltage reference. The first resistance may include an internal resistance of the first diode. The negative voltage clamp may include a second diode and at least one second resistance connected in series therewith. The second resistance may include an internal resistance of the second diode.

The control circuit may include a capacitor connected in series between the negative voltage clamp and the voltage reference and defining a control signal node with the negative voltage clamp. A filter may be connected between the control signal node and the controllable resistance. The controllable resistance may include a metal semiconductor field effect transistor having a pair of conduction terminals connected in series with the RF signal path and a control terminal connected to the filter. The RF signal path may include a pair of balanced RF signal paths. The controllable resistance may include a respective controllable resistance device in series with each balanced RF signal path.

The limiter may include a monolithic microwave integrated circuit. The antenna element may include at least one dipole antenna element. The dipole antenna element may include a coupling end portion for coupling to an adjacent dipole antenna elements end.

A method aspect of the invention is directed to limiting radio frequency (RF) signals on at least one RF signal path extending between an antenna element and a receiver circuit. The method may include clamping the RF signal path to a positive threshold voltage relative to a voltage reference using a positive voltage clamp, and clamping the RF signal path to a negative threshold voltage relative to the voltage reference using a negative voltage clamp. The method may further include controlling a controllable resistance connected in series with the RF signal path based upon at least one of the positive voltage clamp and the negative voltage clamp.

### Brief Description of the Drawings

FIG. 1 is a schematic block diagram of a RF receiver system in accordance with the invention.
FIG. 2 is a schematic circuit diagram of a first embodiment of the limiter of the RF receiver system illustrated in FIG. 1.
FIG. 3 is a schematic circuit diagram of a second embodiment of the limiter of the RF receiver system illustrated in FIG. 1.
FIG. 4 is a graph of impedance variation versus power and frequency for an example of the limiter illustrated in FIG. 1.
FIG. 5 is a graph of the change in return loss for a given frequency for an example of the limiter illustrated in FIG. 1.
FIG. 6 is a graph of the change in gain for an example of the limiter illustrated in FIG. 1.

### Detailed Description of the Preferred Embodiments

The invention will now be described more fully hereinafter with reference to the accompanying drawings, in which preferred embodiments of the invention are shown. This invention may, however, be embodied in many different forms and should not be construed as limited to the embodiments set forth herein. Rather, these embodiments are provided so that this disclosure will be thorough and complete, and will fully convey the scope of the invention to those skilled in the art. Like numbers refer to like elements throughout, and prime notation is used to indicate similar elements in alternative embodiments.

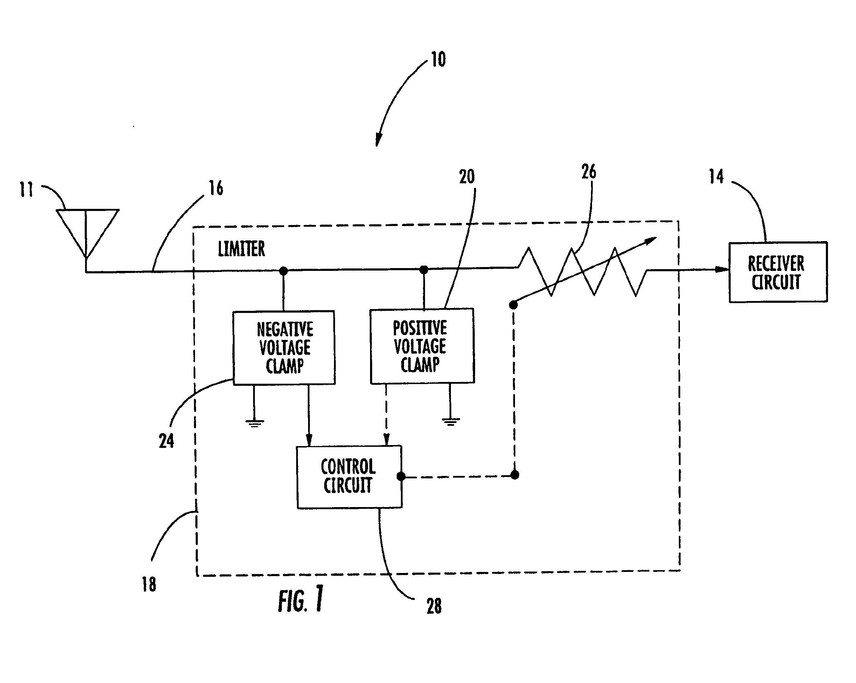

Referring initially to FIG. 1, an RF receiver system **10** in accordance with the invention is now described. The RF receiver system **10** illustratively includes an antenna **11,** a receiver circuit **14,** and at least one RF signal path **16** connecting the antenna to the receiver circuit as will be appreciated by those of skill in the art. The RF receiver system 10 may be used with any antenna.

A limiter **18** is illustratively connected to the RF signal path **16,** and includes a positive voltage clamp **20** for clamping the RF signal path to a positive threshold voltage relative to a voltage reference, and a negative voltage clamp **24** for clamping the RF signal path to a negative threshold voltage relative to the voltage reference. The limiter **18** further includes a controllable resistance **26** connected in series with the RF signal path **16,** and a control circuit **28** for controlling the controllable resistance based upon the negative voltage clamp **24.** The control circuit **28** may switch the controllable resistance **26** from a low resistance to a high resistance based upon at least one of the positive voltage clamp **20** and the negative voltage clamp **24** clamping the RF signal path **16.**

The control circuit **28** may operate based upon the positive voltage clamp **20** in other embodiments as indicated by the dashed connecting line. In yet other embodiments, the control circuit **28** may operate based on both clamps as will be appreciated by those skilled in the art.

As such, the controllable resistance **26** provides broadband burnout protection for the RF receiver circuit **14** as will be appreciated by those skilled in the art. The controllable resistance **26** also provides gradual signal attenuation on the RF signal path **16** that permits the receiver circuit **14** to operate with reduced sensitivity over a wider input power range than a conventional RF limiter (hard limiting) receiver system. The limiter **18** may be in the form of a monolithic microwave integrated circuit, although other circuit configurations are also possible as will be appreciated by those of skill in the art.

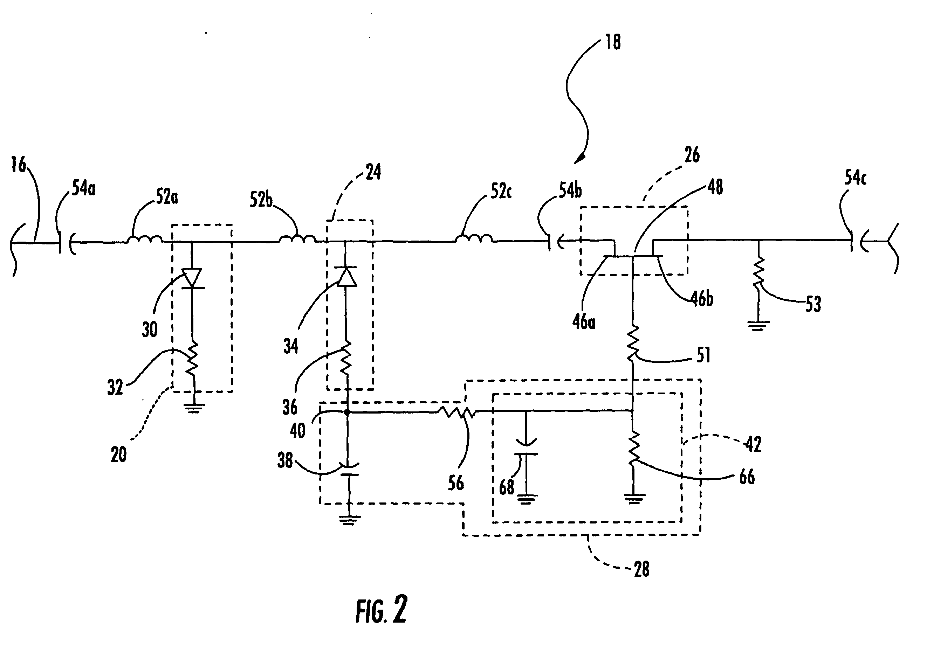

Referring now additionally to FIG. 2, the positive voltage clamp **20** illustratively includes a first diode **30** and a first resistance **32** connected in series therewith between the RF signal path **16** and a voltage reference, e.g. ground. The first resistance **32** may be provided an internal resistance of the first diode **30.** Alternately, the first resistance **32** could be a separate component.

The negative voltage clamp **24** illustratively includes a second diode **34** and a second resistance **36** connected in series therewith. The second resistance **36** may be in the form of an internal resistance of the second diode **34** or may be a separate component. The first resistance **32** primarily, and the second resistance **36** are selected to reduce the reflection of a signal on the RF signal path **16** by absorbing the incident energy rather than reflecting it as will be appreciated by those skilled in the art.

The control circuit **28** includes a capacitor **38** connected in series between the second resistance **36** of the negative voltage clamp **24** and the voltage reference to define a control signal node **40** with the negative voltage clamp. A filter **42** is illustratively connected between the control signal node **40** and the controllable resistance **26.** The filter **42** illustratively includes a fourth resistance **66** connected in parallel with a filter capacitor **68** to the voltage reference. The control circuit **28** also includes a control circuit resistance **56** connected between the filter **42** and the control signal node **40.**

The controllable resistance **26** is illustratively in the form of a metal semiconductor field effect transistor (MESFET) having a pair of conduction terminals **46a, 46b** connected in series with the RF signal path **16** and a gate or control terminal **48** connected to the control circuit **28.** The limiter **18** also illustratively includes tuning inductors **52a-52c** and signal path capacitors **54a-54c,** connected to RF signal path **16.**

The limiter **18** further includes a resistor **51,** which isolates the RF circuit from the filter **42,** and a resistor **53,** which provides the controllable resistance **26** a bias reference. Both resistors **51** and **53** may be selected with large values when compared to the RF characteristic impedance thereby reducing their affect on the RF signal path **16.**

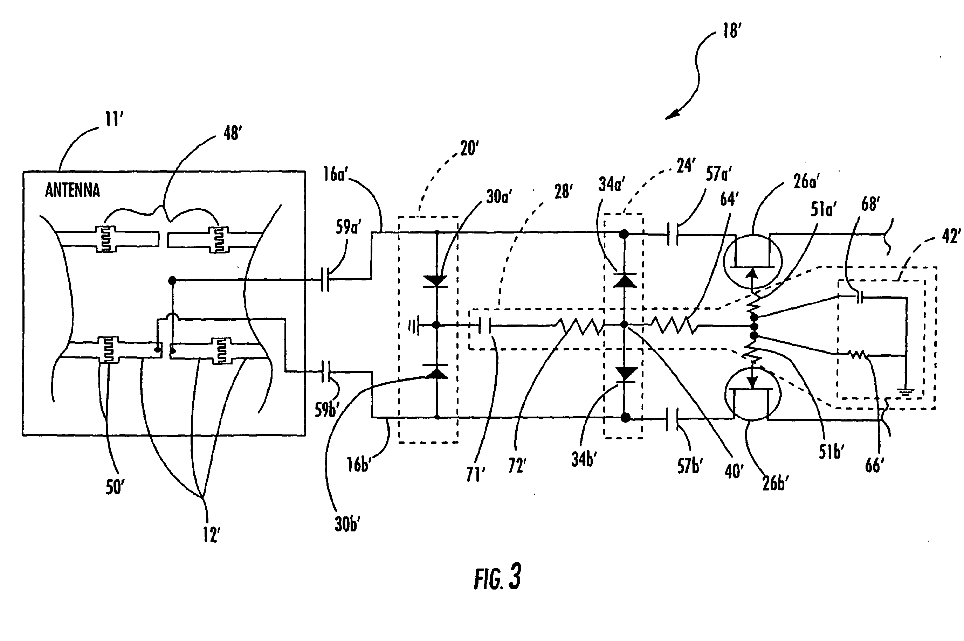

Referring additionally to FIG. 3, in an alternate embodiment, the antenna **11'** is illustratively in the form of a current sheet array antenna and such an antenna has a wide bandwidth. The current sheet array antenna is disclosed in U.S. Patent No. 6,512,487, the entire contents of which are incorporated by reference herein. The antenna element **12'** illustratively includes a dipole antenna element **48'.** The dipole antenna element **48'** includes a coupling end portion **50'** for coupling to an adjacent dipole antenna elements end, for example. The RF signal path includes a pair of balanced RF signal paths **16a', 16b'** connected to a dipole antenna element **48'.** A positive voltage clamp **20'** illustratively includes a pair of diodes **30a', 30b'** connected between respective signal paths **16a', 16b'** and ground. Coupling capacitors **57a', 57b', 59a',** and **59b'** are provided in respective signal paths **16a', 16b'.** A negative voltage clamp **24'** is illustratively connected between respective signal paths **16a', 16b'** and includes a pair of diodes **34a', 34b'.**

Each controllable resistance device **26a', 26b'** includes a control terminal **48'** connected to the control circuit **28'.** The control circuit **28'** is connected to control signal node **40',** and it includes the filter **42'.** A fifth resistance **64'** is connected between the control signal node **40'** and a sixth resistance **72'.** A RF bypass capacitor **71'** is connected between the sixth resistance **72'** and ground.

The limiter **18'** may advantageously operate with a substantially constant impedance while limiting. The limiter **18'** may include additional diodes as will be appreciated by those skilled in the art. The additional diodes should not affect the impedance of the RF receiver system **10.**

As the received power increases in the RF receiver system **10,** the diodes of the limiter **18'** begin to go into conduction providing limiting. The conduction of the diodes also generates a bias voltage for each controllable resistance **26a', 26b'** turning them off. The proper selection of the fifth resistance **64'** and the fourth resistance **66'** may be used to adjust the MESFET bias to maintain the match over a range of input power levels. In addition, the fifth resistance **64'** may be used to provide the isolation between the limiter portion of the circuit and the filter 42'.

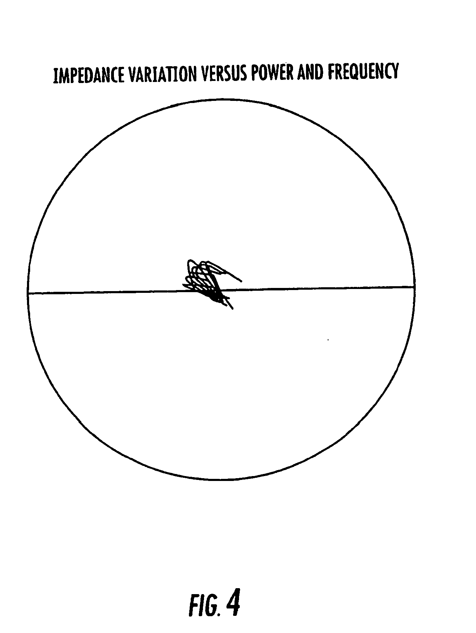

FIGS. 4-6 show a series of graphs illustrating a simulation of the limiter **18'** modeled as a monolithic microwave integrated circuit (MMIC) connected to an antenna. FIG. 4 shows a graph of the complex impedance of the MMIC. Each line shows the change of impedance for a given frequency over an input power range of 10dBm to 30dBm, and a frequency range of 2GHz to 18GHz in 2 GHz steps.

Each of the curved lines at the center of the graph represents a different frequency, and in an ideal plot, there would only be a dot. The graph shows that each curve turns back towards the center when the diodes **31a, 31b** and **33a, 33b** turn on because the load resistances 72' begin absorbing the incident energy. This reduces the amount of incident energy being reflected by the limiter **18'** thereby reducing the reflection of the RF receiver system **10.**

The graph also shows that the input impedance changes very little over the power level. In contrast, if this were a conventional limiter, all the curves that start near the center (good match) would end up at the left edge of the chart in a near short circuit condition in which the incident power would be reflected back out of the antenna.

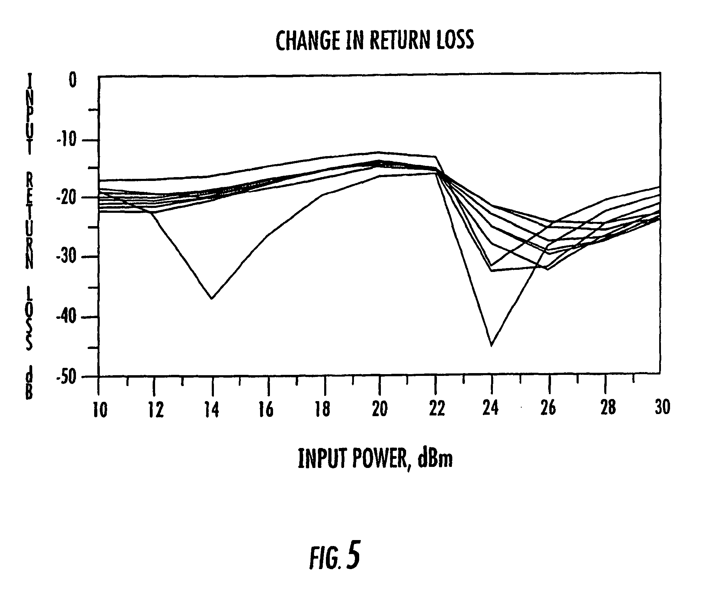

An alternate way to look at the previous simulation results is a graph of the return loss plot as shown in FIG. 5. Again, each return loss line or curve shows the change in return loss for a given frequency from 2GHz to 18GHz. In a conventional limiter, the frequency lines would go to 0dB (total reflection) with increasing power, while the graph shows that the RF receiver system **10** return loss remains within a desirable range.

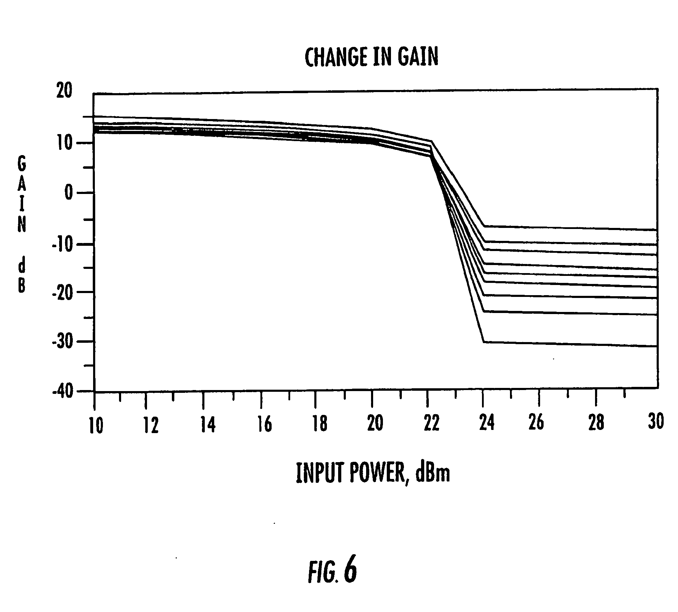

Another highly desirable characteristic of the limiter **18'** is for the limiter to isolate the input power from the more sensitive components of the system. This effect is shown in FIG. 6. Because linear models are used for the active devices in the simulation, no compression effects are produced so the change in gain with increasing power is due to the effect of the limiter **18'.**

The graph shows the limiter **18'** starting to operate at 11dBm and then going to a high attenuation state at higher potentially damaging power levels. The top lines in the plot exhibit 23dB isolation, which improves to more than 40dB at the low end of the 2GHz to 18GHz frequency band.

A method aspect of the invention is directed to limiting RF signals on an RF signal path **16** extending between an antenna element **12** and a receiver circuit **14.** The method may include clamping the RF signal path **16** to a positive threshold voltage relative to a voltage reference using a positive voltage clamp **20,** and clamping the RF signal path to a negative threshold voltage relative to the voltage reference using a negative voltage clamp **24.** The method may further include controlling a controllable resistance **26** connected in series with the RF signal path **16** based upon at least one of the positive voltage clamp **20** and the negative voltage clamp **24.**

## Claims

1. A radio frequency (RF) receiver system comprising:
at least one antenna element (11), a receiver circuit (14), and at least one (RF) signal path (16) connecting said at least one antenna element to said receiver circuit;
a limiter (18) connected to said at least one RF signal path and comprising
a positive voltage clamp (20) for clamping the at least one RF signal path to a positive threshold voltage relative to a voltage reference,
a negative voltage clamp (24) for clamping the at least one RF signal path to a negative threshold voltage relative to the voltage reference, **characterised by**
a controllable resistance (26) connected in series with the at least one RF signal path, and
a control circuit (28) for controlling said controllable resistance (26) based upon at least one of said positive voltage clamp (20) and said negative voltage clamp (34).

2. The RF receiver system according to Claim 1 wherein said control circuit switches said controllable resistance from a low resistance to a high resistance based upon at least one of said positive voltage clamp and said negative voltage clamp clamping the at least one RF signal path.

3. The RF receiver system according to Claim 1 wherein said positive voltage clamp comprises a first diode and at least one first resistance connected in series therewith between the at least one RF signal path and the voltage reference.

4. The RF receiver system according to Claim 3 wherein said at least one first resistance comprises an internal resistance of said first diode.

5. The RF receiver system according to Claim 3 wherein said negative voltage clamp comprises a second diode and at least one second resistance connected in series therewith.

6. The RF receiver system according to Claim 5 wherein said at least one second resistance comprises an internal resistance of said second diode.

7. The RF receiver system according to Claim 5 wherein said control circuit comprises:
a capacitor connected in series between said negative voltage clamp and the voltage reference and defining a control signal node with the negative voltage clamp; and
a filter connected between the control signal node and said controllable resistance.

8. The RF receiver system according to Claim 7 wherein said controllable resistance comprises a metal semiconductor field effect transistor having a pair of conduction terminals connected in series with the at least one RF signal path and a control terminal connected to said filter.

9. The RF receiver system according to Claim 1 wherein said at least one RF signal path comprises a pair of balanced RF signal paths; and wherein said controllable resistance comprises a respective controllable resistance device in series with each balanced RF signal path.

10. A method of limiting radio frequency (RF) signals on at least one RF signal path extending between an antenna element (11) and a receiver circuit (14) the method comprising:
clamping the at least one RF signal path to a positive threshold voltage relative to a voltage reference using a positive voltage clamp (20);
clamping the at least one RF signal path to a negative threshold voltage relative to the voltage reference using a negative voltage clamp (24); and **characterised by**
controlling a controllable resistance connected in series with the at least one RF signal path based upon at least one of the positive voltage clamp and the negative voltage clamp.

## Patentansprüche

1. Funkfrequenz-(RF-) Empfängersystem, aufweisend:
zumindest ein Antennenelement (11), eine Empfängerschaltung (14) und zumindest einen (RF-) Signalpfad (16), der das zumindest eine Antennenelement mit der Empfängerschaltung verbindet;
einen Begrenzer (18), welcher mit dem zumindest einen RF-Signalpfad verbunden ist und welcher aufweist
eine Positivspannungsklemmung (20) zum Anklemmen des zumindest einen RF-Signalpfads an eine positive Schwellwertspannung relativ zu einer Bezugsspannung,
eine Negativspannungsklemmung (24) zum Anklemmen des zumindest einen RF-Signalpfads an eine negative Schwellwertspannung relativ zur Bezugsspannung, **gekennzeichnet durch**
einen steuerbaren Widerstand (26), der mit dem zumindest einen RF-Signalpfad in Reihe geschaltet ist, und
eine Steuerschaltung (28) zum Steuern des steuerbaren Widerstands (26) beruhend auf der Positivspannungsklemmung (20) und / oder der Negativspannungsklemmung (24).

2. RF-Empfängersystem nach Anspruch 1, bei dem die Steuerschaltung den steuerbaren Widerstand von einem niedrigen Widerstand zu einem hohen Widerstand umschaltet, und zwar beruhend auf der Positivspannungsklemmung und / oder der Negativspannungsklemmung, die an dem zumindest einen RF-Signalpfad angeklemmt ist.

3. RF-Empfängersystem nach Anspruch 1, bei dem die Positivspannungsklemmung eine erste Diode und zumindest einen ersten Widerstand aufweist, der damit in Reihe geschaltet ist, und zwar zwischen dem zumindest einen RF-Signalpfad und der Bezugsspannung.

4. RF-Empfängersystem nach Anspruch 3, bei dem der zumindest eine erste Widerstand einen inneren Widerstand der ersten Diode aufweist.

5. RF-Empfängersystem nach Anspruch 3, bei dem die Negativspannungsklemmung eine zweite Diode und zumindest einen zweiten, damit in Reihe geschalteten Widerstand aufweist.

6. RF-Empfängersystem nach Anspruch 5, bei dem der zumindest eine zweite Widerstand einen inneren Widerstand der zweiten Diode aufweist.

7. RF-Empfängersystem nach Anspruch 5, bei dem die Steuerschaltung aufweist:
einen Kondensator, der zwischen der Negativspannungsklemmung und der Bezugsspannung in Reihe geschaltet ist und einen Steuersignalknoten mit der Negativspannungsklemmung definiert; und
ein Filter, das zwischen dem Steuersignalknoten und dem steuerbaren Widerstand geschaltet ist.

8. RF-Empfängersystem nach Anspruch 7, bei dem der steuerbare Widerstand einen Metallhalbleiter-Feldeffekttransistor mit einem Paar von Leitungsanschlüssen aufweist, welche mit dem zumindest einen RF-Signalpfad und einem mit dem Filter verbundenen Steueranschluss in Reihe geschaltet sind.

9. RF-Empfängersystem nach Anspruch 1, bei dem der zumindest eine RF-Signalpfad ein Paar von symmetrischen RF-Signalpfaden aufweist; und bei dem der steuerbare Widerstand eine entsprechende steuerbare Widerstandsvorrichtung in Reihe mit jedem symmetrischen RF-Signalpfad aufweist.

10. Verfahren zum Begrenzen von Funkfrequenz-, RF-, Signalen an zumindest einem RF-Signalpfad, der sich zwischen einem Antennenelement (11) und einer Empfängerschaltung (14) erstreckt, wobei das Verfahren aufweist:
Anklemmen des zumindest einen RF-Signalpfads an eine positive Schwellwertspannung relativ zu einer Bezugsspannung unter Verwendung einer Positivspannungsklemmung (20);
Anklemmen des zumindest einen RF-Signalpfads an eine negative Schwellwertspannung relativ zur Bezugsspannung unter Verwendung einer Negativspannungsklemmung (24); **gekennzeichnet durch**
ein Steuern eines steuerbaren Widerstands, der mit dem zumindest einen RF-Signalpfad in Reihe geschaltet ist, und zwar beruhend auf der Positivspannungsklemmung und / oder der Negativspannungsklemmung.

## Revendications

1. Système récepteur de fréquence radio (RF) comprenant :
au moins un élément d'antenne (11), un circuit récepteur (14) et au moins un parcours (16) du signal (RF) connectant ledit au moins un élément d'antenne audit circuit récepteur ;
un limiteur (18) connecté audit au moins un parcours du signal RF et comprenant :
un verrouillage de tension positive (20) pour verrouiller le au moins un parcours du signal RF à une tension de seuil positive par rapport à une référence de tension,
un verrouillage de tension négative (24) pour verrouiller le au moins un parcours de signal RF à une tension de seuil négative par rapport à la référence de tension, **caractérisé par**
une résistance contrôlable (26) connectée en série à le au moins un parcours de signal RF, et
un circuit de contrôle (28) pour contrôler ladite résistance contrôlable (26) sur la base d'au moins un parmi ledit verrouillage de tension positive (20) et ledit verrouillage de tension négative (24).

2. Système récepteur RF selon la revendication 1, dans lequel ledit circuit de contrôle change ladite résistance contrôlable d'une résistance faible à une résistance élevée sur la base d'au moins un parmi ledit verrouillage de tension positive, et ledit verrouillage de tension négative verrouillant le au moins un parcours du signal RF.

3. Système récepteur RF selon la revendication 1, dans lequel ledit verrouillage de tension positive comprend une première diode et au moins une première résistance connectée en série à celle-ci entre le au moins un parcours du signal RF et la référence de tension.

4. Système récepteur RF selon la revendication 3, dans lequel ladite au moins une première résistance comprend une résistance interne de ladite première diode.

5. Système récepteur RF selon la revendication 3, dans lequel ledit verrouillage de tension négative comprend une deuxième diode et au moins une deuxième résistance connectée en série à celle-ci.

6. Système récepteur RF selon la revendication 5, dans lequel ladite au moins une deuxième résistance comprend une résistance interne de ladite deuxième diode.

7. Système récepteur RF selon la revendication 5, dans lequel ledit circuit de contrôle comprend :
un condensateur connecté en série entre ledit verrouillage de tension négative et la référence de tension et définissant un noeud du signal de commande avec le verrouillage de tension négative ; et
un filtre connecté entre le noeud du signal de commande et ladite résistance contrôlable.

8. Système récepteur RF selon la revendication 7, dans lequel ladite résistance contrôlable comprend un transistor à effet de champ métal-semiconducteur ayant une paire de terminaux de conduction connectés en série à le au moins un parcours du signal RF et un terminal de contrôle connecté audit filtre.

9. Système récepteur RF selon la revendication 1, dans lequel ledit au moins un parcours du signal RF comprend une paire de parcours du signal RF symétriques ; et dans lequel ladite résistance contrôlable comprend un dispositif de résistance contrôlable respectif en série avec chaque parcours du signal RF symétrique.

10. Procédé de limitation des signaux de fréquence radio (RF) sur au moins un parcours du signal RF s'étendant entre un élément d'antenne (11) et un circuit récepteur (14), le procédé comprenant :
le verrouillage de le au moins un parcours du signal RF sur une tension de seuil positive par rapport à une référence de tension en utilisant un verrouillage de tension positive (20) ;
le verrouillage de le au moins un parcours du signal RF sur une tension de seuil négative par rapport à la référence de tension en utilisant un verrouillage de tension négative (24) ; et **caractérisé par**
le contrôle d'une résistance contrôlable connectée en série à le au moins un parcours du signal RF sur la base d'au moins un parmi le verrouillage de tension positive et le verrouillage de tension négative.
